(19) **Europäisches Patentamt European Patent Office Office européen des brevets**

(11) **EP 0 714 030 B1**

(12) **FASCICULE DE BREVET EUROPEEN**

(45) Date de publication et mention de la délivrance du brevet:
**13.08.2008 Bulletin 2008/33**

(51) Int Cl.:
***G01R 29/08*** (2006.01)

(21) Numéro de dépôt: **95402588.8**

(22) Date de dépôt: **17.11.1995**

(54) **Simulateur d'impulsion électromagnétique**

Simulator für elektromagnetische Pulse

Electromagnetic pulse simulator

(84) Etats contractants désignés:
**DE GB IT**

(30) Priorité: **22.11.1994 FR 9413963**

(43) Date de publication de la demande:
**29.05.1996 Bulletin 1996/22**

(73) Titulaire: **THOMSON-CSF COMMUNICATIONS 92700 Colombes (FR)**

(72) Inventeurs:
• **Piro, Frédéric F-75015 Paris (FR)**

• **Blanchet, Marcel F-94400 Vitry s/Seine (FR)**

(74) Mandataire: **Lucas, Laurent Jacques et al Marks & Clerk France 31-33 Avenue Aristide Briand 94117 Arcueil Cedex (FR)**

(56) Documents cités:
**EP-A- 0 517 992      DE-A- 4 300 778**
**FR-A- 2 386 156      FR-A- 2 704 100**
**FR-A- 2 710 193      US-A- 2 407 911**

EP 0 714 030 B1

**Description**

La présente invention porte sur un simulateur d'impulsion électromagnétique, comportant un générateur de l'impulsion simulée et une structure de transmission d'ondes guidées, reliée audit générateur.

L'impulsion électromagnétique simulée est une impulsion d'origine foudre ou plus particulièrement une impulsion d'origine nucléaire, dont le temps de montée très bref est dans ce dernier cas inférieur à 5 ns et de l'ordre ou même inférieur à 1 ns, pour une amplitude de crête supérieure à 50 kV. Un tel simulateur permet de réaliser des tests sur des équipements, matériels ou autres soumis aux effets de l'impulsion simulée.

La structure de transmission d'ondes guidées est également dite antenne du type guide d'ondes. Dans les simulateurs de grandes dimensions, elle est constituée par une nappe filaire formée relativement à un autre réseau de fils en général à la terre. Cette nappe se compose d'une partie ou transition d'entrée reliée au générateur, s'évasant et formant un cornet d'entrée, d'une partie utile, parallèle au réseau de fils à la terre, reliée à la partie d'entrée et définissant avec le réseau de fils un volume de test, et d'une partie ou transition de terminaison reliée d'une part à la partie utile et d'autre part à des charges résistives adaptées, elles-mêmes reliées à la terre, et formant un cornet de sortie.

La partie utile est horizontale dans un simulateur à polarisation verticale ou à polarisation horizontale. La partie d'entrée et la partie de sortie sont toutes deux inclinées par rapport à cette partie utile.

La transition d'entrée et la partie utile forment entre elles une discontinuité géométrique. Celle-ci donne lieu à des perturbations, notamment des phénomènes de réflexion, prenant naissance à son niveau. Ces perturbations se répercutent sur la partie utile et entraînent une modification du courant dans la partie utile et du champ électromagnétique induit dans le volume de test. Du fait de cette discontinuité géométrique, ce champ électromagnétique n'est plus suffisamment représentatif des effets réels de l'impulsion simulée.

Le document FR-A-2 704 100 décrit un tel simulateur, qui comporte en outre des impédances supplémentaires en série sur la transition d'entrée, pour minimiser les perturbations dûes à cette discontinuité géométrique. Ces impédances sont de valeur prédéfinie, qui est déterminée lors d'essais pour atténuer les perturbations et leurs effets. L'atténuation des perturbations ainsi obtenue ne s'avère cependant satisfaisante que sur une longueur limitée de la partie utile de la nappe et en conséquence sur un volume de test relativement réduit.

La présente invention a pour but de s'affranchir des perturbations dues à une telle discontinuité géométrique dans un simulateur du type précité, pour l'obtention d'un champ électromagnétique ayant un temps de montée bref et restant ensuite sensiblement uniforme et donc représentatif de l'onde simulée, dans un volume de test important le long de la partie utile de la nappe filaire.

Elle a pour objet un simulateur d'impulsion électromagnétique, comportant un générateur de l'impulsion électromagnétique simulée, un réseau de fils à la terre et une nappe filaire, ladite nappe étant formée en regard dudit réseau et définissant longitudinalement entre elle et ledit réseau un cornet d'entrée relié audit générateur, un guide rectiligne et un cornet de sortie, en présentant une discontinuité géométrique entre ledit cornet d'entrée et ledit guide rectiligne, caractérisé en ce qu'il comporte en outre une lentille électromagnétique, de conversion d'ondes sphériques en ondes planes, interposée entre ledit cornet d'entrée et ledit guide rectiligne, en s'étendant entre ledit réseau et ladite nappe, pour l'atténuation des perturbations dûes à ladite discontinuité géométrique.

Selon une caractéristique additionnelle, ladite lentille électromagnétique est à milieu diélectrique en bois, de préférence, ou à milieu diélectrique artificiel.

Les caractéristiques et avantages de la présente invention ressortiront de la description faite ci-après d'un mode préféré de réalisation donné à titre d'exemple et illustré dans les dessins ci-annexés. Dans ces dessins :

- la figure 1 représente schématiquement un simulateur d'une impulsion électromagnétique d'origine nucléaire, selon la présente invention,
- la figure 2 est une vue de dessous et à échelle agrandie de la lentille électromagnétique utilisée dans le simulateur de la figure 1,
- les figures 3 à 5 sont des courbes illustrant l'évolution de la composante verticale EZ du champ électrique en fonction du temps, en trois points du volume de test d'un simulateur avec et sans la lentille électromagnétique,
- la figure 6 reproduit les trois courbes précitées obtenues lorsque le simulateur utilise cette lentille électromagnétique, en vue d'une comparaison directe de ces courbes.

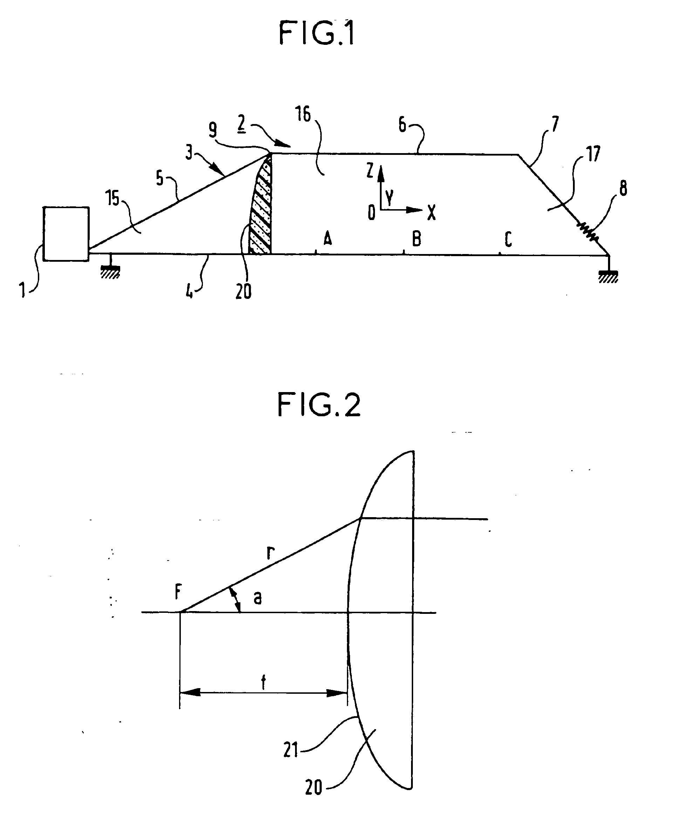

Le simulateur représenté dans la figure 1 est un dispositif de grandes dimensions et à polarisation verticale. Il comporte un générateur 1 de l'impulsion simulée et une structure de transmission d'ondes guidées 2, dite également antenne du type guide d'ondes. Cette structure ou antenne de transmission est constituée par une nappe filaire 3 et un réseau ou une autre nappe de fils 4 à la terre.

Le réseau de fils 4 est horizontal, est constitué de préférence par une treillis de fils entrecroisés ou par des feuilles de cuivre ou autre matériau bon conducteur et est d'une part relié à la masse du générateur et d'autre part mis à la terre.

Le générateur 1 est en tant que tel connu. Il est en particulier constitué par un générateur de Marx capable de délivrer des tensions de plusieurs centaines de kV, couplé à un étage éclateur de sortie destiné à délivrer une impulsion, de front de montée très raide et d'amplitude très élevée, dont l'allure est celle d'une double exponentielle, pour la production d'un champ électromagnétique correspondant.

La nappe 3 est constituée de fils reliés au générateur 1. Elle se décompose en une partie d'entrée 5, reliée au générateur 1 et inclinée sur l'horizontale, une partie utile 6, horizontale et reliée à la partie d'entrée 5, et une partie de sortie 7, inclinée sur l'horizontale et d'une part reliée à la partie utile 6 et d'autre part par des charges résistives adaptées 8 en série sur chaque fil au réseau 4 et donc à la terre. Sur la partie utile, les fils sont parallèles et équidistants les uns des autres.

Cette nappe filaire présente une discontinuité géométrique 9 entre la partie d'entrée 5 et la partie utile 6. Elle forme, avec le réseau 4, un cornet d'entrée 15, un guide rectiligne 16 et un cornet de sortie 17, à la suite les uns des autres. Le volume de test est défini sur une partie du guide rectiligne.

Le simulateur comporte en outre selon l'invention une lentille électromagnétique 20 interposée entre le cornet d'entrée 15 et le guide rectiligne 16. Cette lentille s'étend verticalement depuis le réseau 4 jusqu'au niveau de la discontinuité géométrique 9 de la nappe 3. Cette lentille est prévue pour assurer la conversion directe des ondes sphériques se propageant dans le cornet d'entrée 15 en ondes planes reçues et se propageant dans le guide rectiligne 16. Elle atténue très fortement les réflexions dûes à la discontinuité géométrique 9 et évite le rayonnement des composantes HF en dehors de la structure de guidage.

Cette lentille permet ainsi d'obtenir un champ électromagnétique avec un temps de montée très bref, pouvant être inférieur à 2 ns, dont la valeur reste ensuite sensiblement uniforme, ceci dans un volume minimal de test souhaité d'au moins 20 m x 2 m x 2 m.

Dans cette figure 1, on a indiqué en A et C les deux limites du volume de test, le long du guide rectiligne. On précise que la limite A, la plus proche de la lentille, est définie en tenant compte de la zone d'ombre existant à l'arrière de la lentille, cette zone d'ombre étant de l'ordre de 5 m de longueur pour la lentille de l'ordre de 4 m de haut. La limite C, la plus éloignée de cette lentille, est définie par la transition entre le guide rectiligne et le cornet de sortie. La distance AC prévue d'au moins 20 m peut atteindre jusqu'à 30 voire 40 m si souhaité. Le point B est un point intermédiaire, ici le point milieu entre A et B.

La figure 2 illustre la lentille 20. Celle-ci est de forme semi-sphérique. Elle présente une surface convexe d'entrée 21, tournée vers le cornet d'entrée, qui est globalement un demi-hyperboloïde. Sa directrice r satisfait l'équation :

$$r = \frac{(n-1)f}{n \cos a - 1}$$

dans laquelle n est l'indice de réfraction supérieur à 1 du diélectrique, f la distance focale et a le demi angle au sommet de la lentille demi-sphérique.

Cette lentille est massive et réalisée en matériau diélectrique de constante diélectrique de l'ordre de 2,5 ou est constituée par un diélectrique artificiel équivalent.

Avantageusement, compte-tenu des dimensions très importantes de la lentille incorporée au simulateur selon l'invention, cette lentille est réalisée en bois naturel ou en contreplaqué ou en bois reconstitué, de manière à minimiser son coût.

La lentille illustrée est à simple foyer F. Elle peut en variante être à double foyer et alors être constituée par deux lentilles électromagnétiques accolées ou non l'une contre l'autre. Dans ce cas, l'une des deux lentilles est analogue à celle illustrée dans la figure 2 tandis que la deuxième lentille, de même type mais plus petite, est positionnée en amont de la précédente et a une face convexe plus bombée. Lorsque ces deux lentilles sont accolées l'une contre l'autre la face plane de la deuxième lentille est directement rapportée contre la face d'entrée convexe de la première, sur laquelle est prévu un méplat correspondant.

Cette lentille électromagnétique, simple ou double et avantageusement en bois, est réalisée par assemblage de plaques de contreplaqué. La face convexe d'entrée est obtenue par la tranche rendue arquée. En variante la tranche des plaques est droite pour l'obtention d'une face d'entrée échelonnée, les échelons pouvant avoir une épaisseur de l'ordre de 3 cm, sans création pour autant de défauts réels pour la longueur d'onde guidée de quelques centaines de MHz dans ce simulateur.

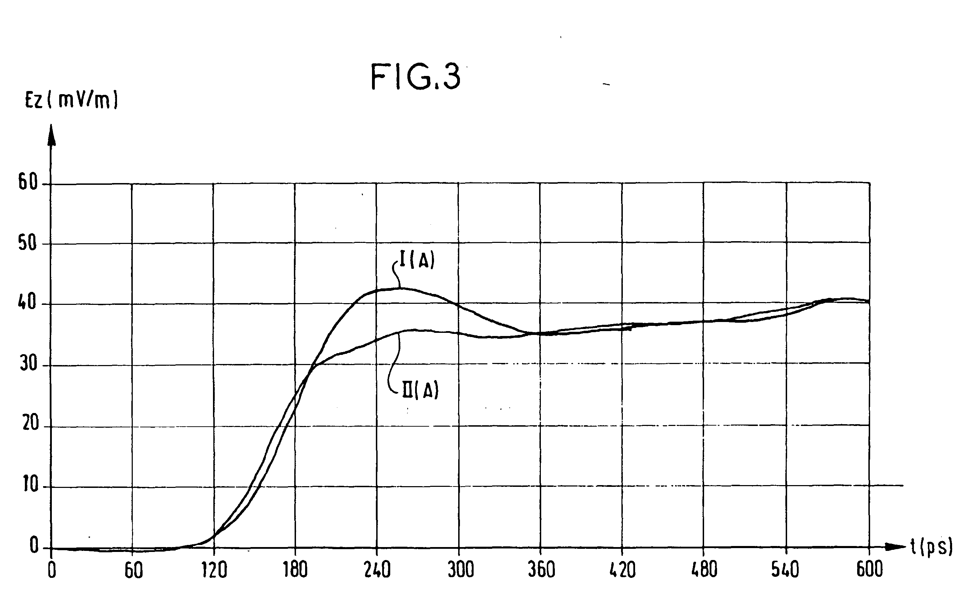

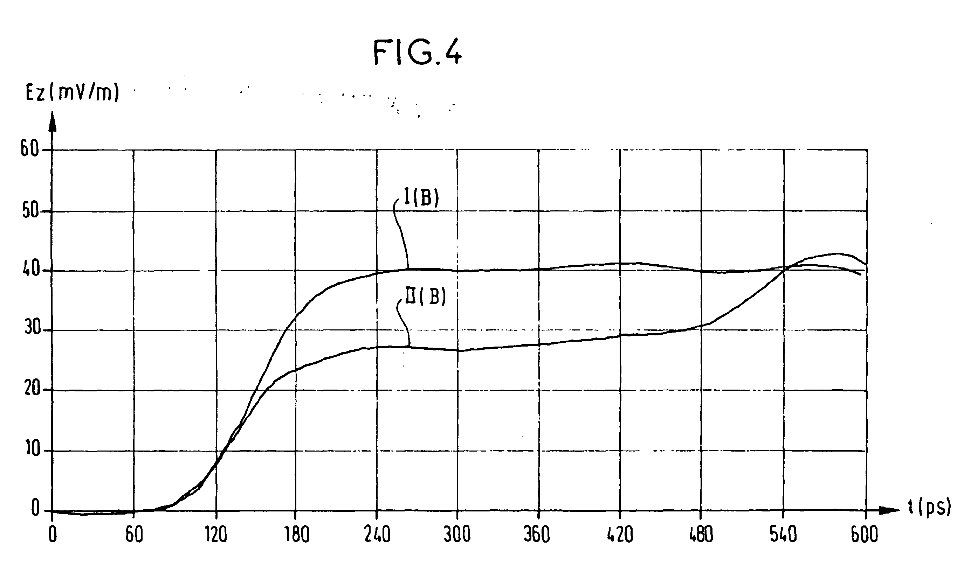

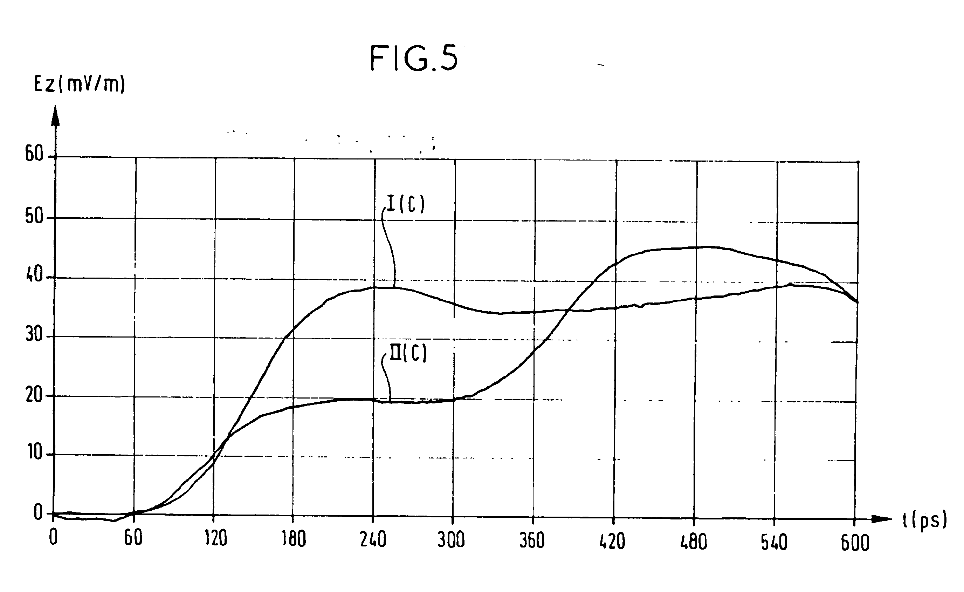

Les figures 3 à 5 montrent des couples de courbes notées I(A), I(B) et I(C) et II(A), II(B) et II(C) d'évolution d'une composante Ez du champ électrique E dans le temps, aux points A, B et C indiqués dans la figure 1, les courbes I étant obtenues lorsque le simulateur est muni conformément à l'invention de sa lentille électromagnétique et les courbes II lorsque le simulateur est sans lentille.

Ces courbes résultent d'expérimentation, faite pour des raisons pratiques sur un simulateur de dimensions plus faibles que celles possibles et souhaitées, dans lequel la nappe 3 est constituée de 16 fils, dont la partie utile horizontale est de 3 m de long, et le générateur d'impulsion utilisé délivre un créneau de tension, dit unitaire, d'amplitude de crête de 10 V, de temps de montée de 50 ps et de largeur de 10 ns. Elles sont données en référence au repère orthonormé dextrogyre OXYZ, illustré dans la figure 1, dans lequel est décomposé le champ électrique E et dont les axes OX et OY sont horizontaux et définis selon la longueur et la largeur du guide rectiligne et l'axe OZ est vertical dans le guide. Dans cette expérimentation, on indique également que la durée d'analyse de cette composante Ez a été limitée à 500 ps environ par le capteur utilisé, à partir d'une durée d'acquisition apparaissant de l'ordre 100 ps dans ces figures mais en pratique légèrement plus longue.

Ces couples de courbes de chacune des figures 3 à 5 font directement ressortir l'effet de cette lentille, ainsi que traduit sur les courbes I par un seul réel front de montée continu de la composante EZ, alors que les courbes II(B) et II(C) présentent des fronts de montée successifs de la composante Ez et ont leur front initial de montée d'autant plus tronqué que l'on s'éloigne du point A et ont une discontinuité de pente entre ce front initial et le deuxième front de montée d'autant plus longue que l'on s'éloigne également du point A.

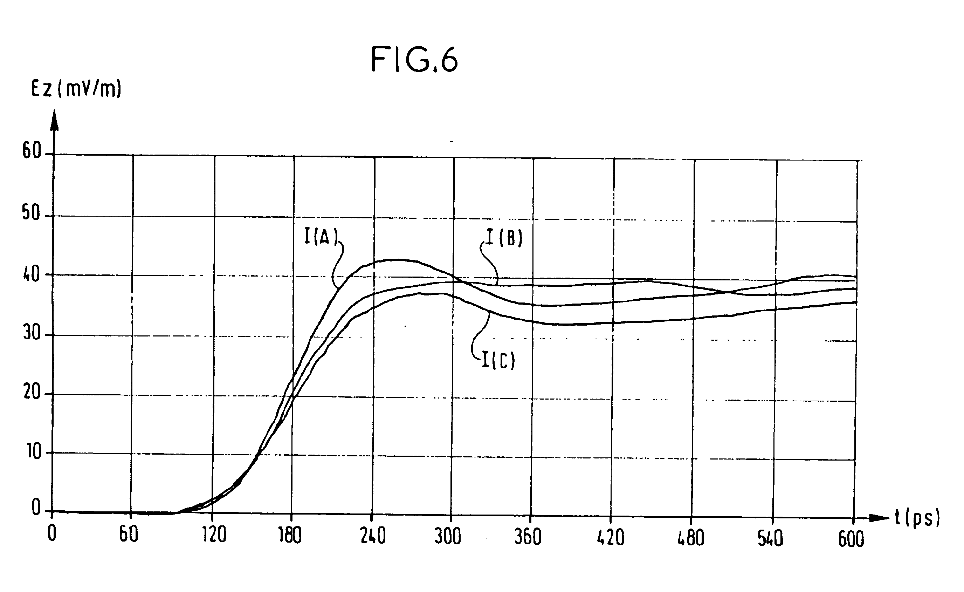

La figure 6 dans laquelle les trois courbes I(A), I(B) et I(C) sont reproduites fait quant à elle ressortir clairement que la composante Ez du champ E est sensiblement uniforme aux points A, B et C précités.

Le simulateur selon l'invention permet l'obtention d'un champ électromagnétique dont la variation est inférieure à $\pm$ 1 dB entre deux points situés le long du guide rectiligne et espacés l'un de l'autre de plus de 20 m.

En outre, on précise que la présence de cette lentille électromagnétique n'affecte pas de manière sensible les composantes du champ suivant les axes OX et OY.

## Revendications

1. - Simulateur d'impulsion électromagnétique, comportant un générateur de l'impulsion électromagnétique simulée, un réseau de fils à la terre et une nappe filaire, ladite nappe étant formée en regard dudit réseau, et définissant entre elle et ledit réseau un cornet relié audit générateur, un guide rectiligne et un cornet de sortie, en présentant une discontinuité géométrique entre ledit cornet d'entrée et ledit guide rectiligne, **caractérisé en ce qu'**il comporte en outre une lentille électromagnétique (20), de conversion d'ondes sphériques en ondes planes, interposée entre ledit cornet d'entrée (15) et ledit guide rectiligne (16), en s'étendant entre le réseau (4) et ladite nappe (3), pour l'atténuation des perturbations dûes à ladite discontinuité géométrique (9).

2. - Simulateur selon la revendication 1, **caractérisé en ce que** ladite lentille électromagnétique (20) est à milieu diélectrique en bois.

3. Simulateur selon la revendication 1, **caractérisé en ce que** ladite lentille électromagnétique (20) est à milieu diélectrique artificiel.

4. Simulateur selon l'une des revendications 2 et 3 **caractérisé en ce que** ladite lentille est à double foyer et constituée de deux lentilles individuelles montées l'une devant l'autre, en étant accolées ou non.

5. Simulateur selon la revendication 4, **caractérisé en ce que** la lentille individuelle la plus arrière des deux lentilles individuelles et accolées présente un méplat avant pour l'autre lentille individuelle.

## Claims

1. Electromagnetic pulse simulator, comprising a generator of the simulated electromagnetic pulse, an array of wires on the earth and a wire net, the said wire net being formed opposite the said array, and defining between it and the said array a horn linked to the said generator, a rectilinear guide and an exit horn, while exhibiting a geometric discontinuity between the said imput horn and the said rectilinear guide, **characterized in that** it furthermore comprises an electromagnetic lens (20), for converting spherical waves to plane waves, interposed between the said entry horn (15) and the said rectilinear guide (16), while extending between the array (4) and the said wire net (3), for attenuating the disturbances due to the said geometric discontinuity (9).

2. Simulator according to Claim 1, **characterized in that** the said electromagnetic lens (20) is made of a wooden dielectric medium.

3. Simulator according to Claim 1, **characterized in that** the said electromagnetic lens (20) is made of an artificial dielectric medium.

4. Simulator according to one of Claims 2 and 3, **characterized in that** the said lens is dual-focus and consists of two individual lenses mounted one in front of the other, the said lenses being adjoining or otherwise.

5. Simulator according to Claim 4, **characterized in that** the rearmost individual lens of the two individual and adjoining lenses exhibits a front flattening for the other individual lens.

## Patentansprüche

1. Simulator eines elektromagnetischen Impulses, der einen Generator des simulierten elektromagnetischen Impulses, ein Netz von geerdeten Drähten und eine Drahtlage aufweist, wobei die Lage gegenüber dem Netz geformt ist und zwischen sich und dem Netz einen mit dem Generator verbundenen Hornstrahler, einen geradlinigen Leiter und einen Ausgangs-Hornstrahler definiert, indem sie eine geometrische Diskontinuität zwischen dem Eingangs-Hornstrahler und dem geradlinigen Leiter aufweist, **dadurch gekennzeichnet, dass** er außerdem eine elektromagnetische Linse (20) zur Umwandlung von Kugelwellen in ebene Wellen, die zwischen dem Eingangs-Hornstrahler (15) und dem geradlinigen Leiter (16) angeordnet ist, indem sie sich zwischen dem Netz (4) und der Lage (3) erstreckt, zur Dämpfung der Störungen aufgrund der geometrischen Diskontinuität (9) aufweist.

**2.** Simulator nach Anspruch 1, **dadurch gekennzeichnet, dass** die elektromagnetische Linse (20) ein dielektrisches Medium aus Holz hat.

**3.** Simulator nach Anspruch 1, **dadurch gekennzeichnet, dass** die elektromagnetische Linse (20) ein künstliches dielektrisches Medium hat.

**4.** Simulator nach einem der Ansprüche 2 und 3, **dadurch gekennzeichnet, dass** die Linse einen doppelten Brennpunkt hat und aus zwei einzelnen Linsen besteht, die miteinander verbunden oder nicht eine vor der der anderen montiert sind.

**5.** Simulator nach Anspruch 4, **dadurch gekennzeichnet, dass** die am weitesten hinten befindliche einzelne Linse der zwei einzelnen und verbundenen Linsen eine vordere Abflachung für die andere einzelne Linse aufweist.

# FIG.1

# FIG.2

FIG.3

EP 0 714 030 B1

FIG.4

EP 0 714 030 B1

FIG.5

FIG.6

**RÉFÉRENCES CITÉES DANS LA DESCRIPTION**

**Documents brevets cités dans la description**

- FR 2704100 A